# EUROPÄISCHE PATENTSCHRIFT

(11) **EP 1 038 306 B1**
(45) Veröffentlichungstag und Bekanntmachung des Hinweises auf die Patenterteilung: **28.04.2004**
(21) Anmeldenummer: 98964488.5
(22) Anmeldetag: 08.12.1998
(51) Int. Cl.: H01J 37/32

(54) **VERFAHREN UND VORRICHTUNG ZUM VERGÜTEN VON OBERFLÄCHEN**
METHOD AND DEVICE FOR IMPROVING SURFACES
PROCEDE ET DISPOSITIF POUR L'AMELIORATION DE SURFACES

(30) Priorität: 08.12.1997 DE 19755902
(43) Veröffentlichungstag der Anmeldung: 27.09.2000
(73) Patentinhaber: Fraunhofer-Gesellschaft zur Förderung der angewandten Forschung e.V., 80686 München (DE)
(72) Erfinder: JUNG, Thomas, D-38173 Hötzum (DE)
(74) Vertreter: Pfenning, Meinig & Partner
(86) Internationale Anmeldenummer: PCT/EP1998/007910
(87) Internationale Veröffentlichungsnummer: WO 1999/030347

(56) Entgegenhaltungen:
- EP-A- 0 634 778
- EP-A- 0 727 508
- PATENT ABSTRACTS OF JAPAN vol. 014, no. 342 (C-0743), 24. Juli 1990 & JP 02 125864 A (CITIZEN WATCH CO LTD), 14. Mai 1990
- PATENT ABSTRACTS OF JAPAN vol. 018, no. 684 (E-1650), 22. Dezember 1994 & JP 06 275547 A (FUJI ELECTRIC CO LTD), 30. September 1994

## Beschreibung

Die Erfindung betrifft ein Verfahren und eine Vorrichtung zum Vergüten von Oberflächen, bei denen die Oberflächen von Gegenständen durch Aufbringen einer Schicht oder durch Modifizieren der oberflächennahen Bereiche die Oberflächeneigenschaften des Gegenstandes verbessert werden.

Schichten, die sehr fest sind und daher sehr dünn sein können, lassen sich meist nur mit plasmagestützten Verfahren aufbringen, da die Gleichgewichtstemperaturen für die Schichtbildung sehr hoch sind (meist weit über 800° C) und die meisten Gegenstände bei derartigen Temperaturen geschädigt werden.

Die simultane plasmagestützte Beschichtung großer Flächen mit Schichten von hervorragender Qualität ist bisher nur im Hoch- oder Feinvakuum gelungen. Beispiele sind das Magnetronsputtern, das plasmaaktivierte Bedampfen, die Vakuumbogenbeschichtung und das HF-CVD-Verfahren. Hoch- oder Feinvakuumverfahren haben jedoch den Nachteil, daß der apparative Aufwand für die Vakuumerzeugung hoch ist und sich außerdem die Behandlungszeit um die Zeiten der Evakuierung und Belüftung der Behandlungskammer verlängert.

Bekannte Verfahren, die im Grobvakuum oder auch bei Atmosphärendruck arbeiten, sind das Plasmaspritzen und das RPJ-Verfahren (radio frequency plasma jet, L. Bardos u.a., Surface and Coatings Technology 72 (1995), S. 174-180). Diese Verfahren erreichen zwar sehr hohe Schichtaufwachsraten, jedoch nur auf sehr kleiner Fläche von wenigen mm² bis cm². Zwar können diese düsenartigen Beschichtungswerkzeuge zur Beschichtung größerer Flächen mittels eines Roboters bewegt werden, um jedoch in kurzer Zeit große Materialmengen abscheiden zu können, muß dem Werkzeug eine extrem hohe elektrische Leistung zugeführt werden, die zu großen Wärme- und Materialproblemen bei dem Werkzeug selbst führt.

Nachteilig bei diesem Verfahren ist weiter, daß der Materialtransport durch einen extremen intensiven Gasstrom mit sehr hoher Gasgeschwindigkeit bewirkt wird, wodurch sich ein hoher Verbrauch an Arbeitsgas ergibt.

Außerdem weisen die mit großen lokalen Schichtaufwachsraten aufgewachsenen Schichten meistens eine verminderte Qualität auf, beim Plasmaspritzen kommt es lediglich zu einer Kondensation aufgeschmolzener Tröpfchen, die keine besonders innige Verbindung untereinander und zum Substrat eingehen und außerdem ein dichtes Netzwerk von Poren bilden. Beim RPJ-Verfahren kommt hinzu, daß die Energie in Form von Hochfrequenz zugeführt werden muß und mit sehr geringem Wirkungsgrad umgesetzt wird, so daß insgesamt beträchtliche Kosten für die Stromversorgung entstehen.

Bekannt ist weiterhin ein Verfahren zur Behandlung von Substratoberflächen, bei dem die Plasmaaktivierung durch eine Hohlkathoden-Glimmentladung hervorgerufen wird (DE 195 05 268) und zur Unterdrückung einer Beschichtung der Kathodenoberfläche Inertgas durch die Hohlkathode geleitet wird. Dieses Verfahren hat jedoch vier entscheidende Nachteile. Erstens wird für eine wirksame Reaktivgasverdrängung von der Hohlkathode sehr viel Inertgas verbraucht. Zweitens sind sehr große Vakuumpumpen erforderlich, um das verbrauchte Inertgas an Atmosphäre zu pumpen. Drittens geht ein großer Teil der Plasmaenergie verloren, da das Reaktivgas nicht in die Zone der größten Plasmaintensität gelangt und viertens kann das Verfahren nur kurzzeitig mit sehr geringer Leistung und damit geringer Schichtaufwachsrate durchgeführt werden, da keine Kathodenkühlung vorgesehen ist und es dadurch zur Überwärmung und Zerstörung der Kathode sowie zur Schädigung des Substrats kommt. Insofern eine Kühlung vorgesehen wird, ergibt sich der gravierende Nachteil, daß bei einer Vervielfältigung der Hohlkathoden durch das Kühlsystem ein hoher konstruktiver Aufwand entsteht und außerdem die Größe der Einzelhohlkathode plus Abstand zur Nachbar-Hohlkathode einen Mindestwert aufweisen muß, wodurch das Verfahren auf einen Druckbereich unterhalb etwa 10 mbar beschränkt bleibt, was entsprechend Vakuumkosten verursacht.

Der Erfindung liegt daher die Aufgabe zugrunde, ein Verfahren und eine Vorrichtung zum Vergüten von Oberflächen zu schaffen, die sowohl im Grobvakuum als auch bei Atmosphärendruck betrieben werden können und mit denen eine Vergütung hoher Qualität mit gutem Wirkungsgrad und ohne oder nur geringem Inertgasverbrauch erzielt wird.

Diese Aufgabe wird erfindungsgemäß durch die Merkmale der unabhängigen Ansprüche gelöst.

Es hat sich überraschend gezeigt, daß sich die Hohlkathode bei einer hinreichend hohen Kathodentemperatur selbstreinigt, das heißt die vom Reaktivgas herrührenden parasitären Beläge desorbiert, verdampft, zerstäubt oder aufgelöst oder zumindest elektrisch leitfähig werden. Dadurch ist ein stabiler Betrieb der Hohlkathode auch ohne starken Inertgasfluß möglich.

Durch die in den Unteransprüchen angegebenen Maßnahmen sind vorteilhafte Weiterbildungen und Verbesserungen möglich.

Dadurch, daß die Hohlkathode sich selbstreinigt, kann das Reaktivgas, dem Inertgas zur Verdünnung beigemischt sein kann, ganz oder teilweise durch die Hohlkathoden geleitet werden, wodurch sich der Wirkungsgrad verbessert, da das Reaktivgas in die Zone der größten Plasmaintensität geleitet werden kann.

Die im geringen Abstand zur Hohlkathode angeordnete gekühlte Anode ermöglicht eine Kühlung der Hohlkathode, so daß die Temperatur der Hohlkathode unter Berücksichtigung der Wärmeableitung durch das Reaktivgas auf die Selbstreinigungstemperatur stabilisiert, d.h. auf definierten Temperaturverhältnissen gehalten werden kann. Zusätzlich kann zwischen Anode und Kathode ein Wärmewiderstand vorgesehen werden.

Die Form der Kathode kann an die Form der zu behandelnden Gegenstände angepaßt werden, wodurch die Hohlkathode nahe an die zu behandelnde Fläche herangebracht werden kann, wodurch auch mit höherem Druck gearbeitet werden kann. Dies wird weiter dadurch gefördert, daß die Hohlkathode aus einer Mehrzahl von matrixartig angeordneten Hohlkathodenelementen gebildet wird.

Beispielsweise zur Erzeugung von Strukturen auf der Oberfläche kann diese lokal oder lokal unterschiedlich behandelt werden, indem beispielsweise die Hohlkathodenmatrix als Art "Maske" ausgebildet ist bzw. entsprechend der gewünschten Struktur die Form der Hohlkathoden angepaßt wird.

Ausführungsbeispiele sind in der Zeichnung dargestellt und werden in der nachfolgenden Beschreibung näher erläutert. Es zeigen:
- Fig. 1: eine schematische Darstellung eines ersten Ausführungsbeispiels der erfindungsgemäßen Behandlungsanordnung,
- Fig. 2: eine schematische Darstellung eines zweiten Ausführungsbeispiels der erfindungsgemäßen Behandlungsanordnung,
- Fig. 3: eine schematische Ansicht eines dritten Ausführungsbeispiels der erfindungsgemäßen Behandlungsanordnung,
- Fig. 4: eine schematische Ansicht eines vierten Ausführungsbeispiels der erfindungsgemäßen Behandlungsanordnung, und
- Fig. 5: eine Aufsicht auf zwei Ausführungsformen von Hohlkathoden.

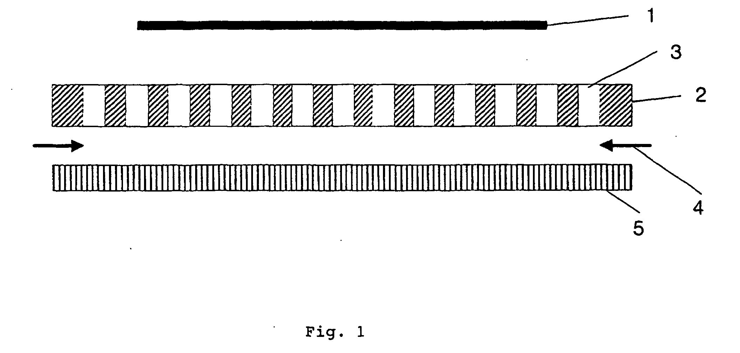

Die in Fig. 1 dargestellte Anordnung zum Vergüten der Oberfläche weist ein Substrat 1 auf, dem eine Hohlkathode 2 gegenüberliegt und parallel zur Hohlkathode 2 ist eine gekühlte Anode 5 vorgesehen. Die gekühlte Anode 5 kann als Metallplatte mit Kühlkanälen für den Durchfluß eines Kühlmediums ausgebildet sein, wodurch sie auf eine definierte Temperatur gekühlt wird. Mit 4 ist eine Reaktivgaszufuhr bezeichnet, wobei das Reaktivgas von der dem Substrat 1 abgewandten Seite eingeleitet wird, so daß das Reaktivgas durch die Hohlkathode 2 hindurchströmt. Die Anordnung kann in einer Vakuumkammer aufgenommen sein, die mit entsprechenden Pumpen zur Herstellung des Vakuums versehen ist.

Die Hohlkathode 2 besteht vorzugsweise aus einer Vielzahl von Hohlkathodenelementen 3, die matrixförmig angeordnet sind und beispielsweise aus einem gelochten Blech oder Körper hergestellt sind. Im Ausführungsbeispiel bilden die Hohlkathodenelemente 3 eine planare oder fast planare Matrix.

Als Reaktivgas können Siliziumverbindungen, Kohlenwasserstoffe, zum Beispiel Ethin, H₂, O₂ oder N₂ verwendet werden. Es kann aber auch kleine Mengen von Inertgas, zum Beispiel Argon umfassen, durch das das Reaktivgas verdünnt wird.

Nach Anlegen einer Spannung zwischen Anode 5 und Hohlkathode 2 und Zuführen des Reaktivgases findet eine Glimmentladung in den einzelnen Hohlkathodenelementen 3 statt. Dabei kann im Vakuum, insbesondere Grobvakuum bei Verwendung einer Vakuumkammer oder bei Atmosphärendruck gearbeitet werden. Das Plasma der Hohlkathodenentladung aktiviert das sich in der Hohlkathode 2 und im Zwischenraum zwischen Hohlkathode 2 und Substrat 1 befindende Gas, wodurch Oberflächenveränderungen durch Kondensation von Teilchen (Schichtbildung) , durch chemische Oberflächenreaktion oder durch Beschuß mit energiereicheren Teilchen (Abtrag, Eindiffusion) am Substrat 1 bewirkt werden. Kondensierte Teilchen sind chemische Reaktionsprodukte aus dem Gas.

Um die während des Prozesses auftretenden parasitären Beläge, die vom Reaktivgas rühren, mit ausreichender Geschwindigkeit zu entfernen oder umzuwandeln, damit sie später leicht entfernt werden können, wird die Hohlkathode 2 auf eine Selbstreinigungstemperatur gebracht und auf dieser definierten Temperatur gehalten. Die Heizung der Hohlkathode 2 erfolgt vorzugsweise durch die Glimmentladung in der Kathode selbst. Die Selbstreinigungstemperatur wird unter Berücksichtigung dieser Temperaturerhöhung durch die Glimmentladung und der Wärmeleitung durch das Arbeitsgas sowie der Strahlung zu der parallel zur Hohlkathode 2 in geringem Abstand angeordneten gekühlten Anode 5 eingestellt und stabilisiert. Falls notwendig kann zwischen der Anode und der Kathode ein als Isolator ausgebildeter Wärmewiderstand zum Beispiel eine Keramikplatte vorgesehen sein.

Bei der Selbstreinigungstemperatur werden die parasitären Beläge desorbiert, verdampft, zerstäubt, aufgelöst und zumindest elektrisch leitfähig gemacht.Die Selbstreinigungstemperatur hängt insbesondere von dem abzuscheidenden Schichtmaterial und dem dafür eingesetzten Reaktivgas ab und beträgt zum Beispiel bei Schichten aus amorphem Kohlenstoff 400° C.

Unter Oberflächenveränderungen, die bei dem Verfahren auftreten, werden die folgenden Prozesse angesehen: chemische Abscheidung von Schichten aus der Gasphase, zum Beispiel kohlenstoffhaltige Schichten aus Methan oder siliziumhaltige Schichten aus Hexamethyldisiloxan; Reinigen mit plasmaaktiviertem Sauerstoff (Verbrennung von Kohlenwasserstoff-Belägen) oder Sauerstoff (Reduktion von Oxidbelägen); Reinigen durch (Inertgas-)Ionenbeschuß in Verbindung mit einer Substratvorspannung; Aktivieren von Kunststoff-Oberflächen zwecks besserer Haftung von Schichten, zum Beispiel Lack, durch Teilchenbeschuß; Beschuß mit Stickstoff-, Bor- oder Kohlenstoff-Ionen zur Bildung einer Diffusionsschicht.

Entsprechend den unterschiedlichen Prozessen werden die Verfahrensparameter eingestellt. Die angelegte Spannung kann zwischen 10 V und 2000 V liegen, es kann Gleichspannung oder Wechselspannung im Niederfrequenz-, Mittelfrequenz-, Hochfrequenz- oder Mikrowellenbereich, sowie gepulste Gleichspannung oder Gleichspannung mit Pulsüberlagerung gewählt werden. Der Druckbereich kann zwischen 1 mbar und 2bar liegen.

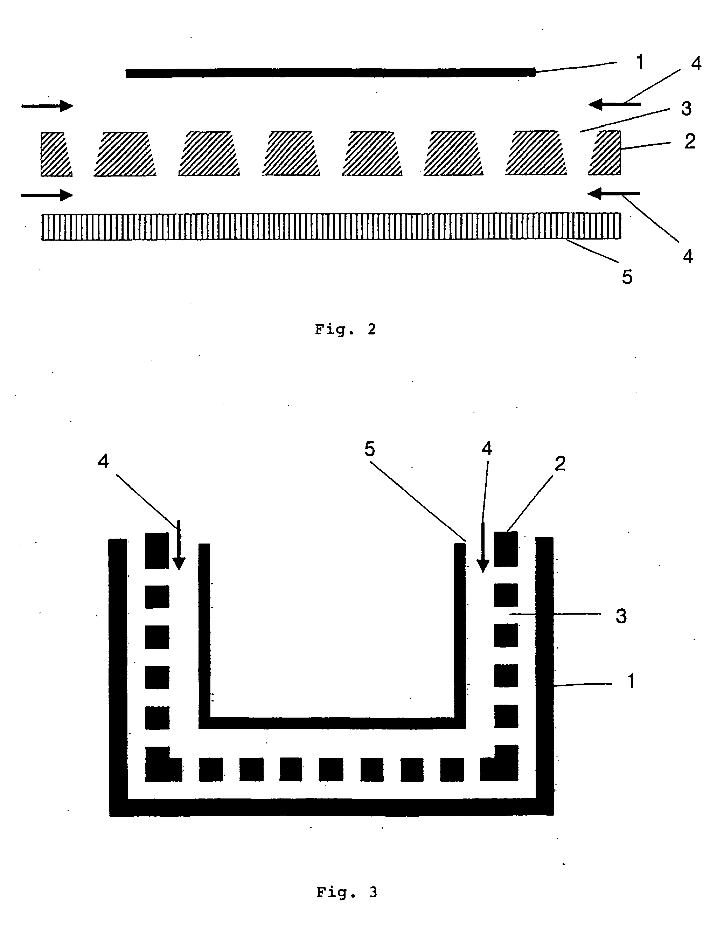

In Fig. 2 ist ein weiteres Ausführungsbeispiel dargestellt, wobei das Reaktivgas zusätzlich zu dem Gaseinlaß 4 nach Fig. 1 in den Bereich zwischen Substrat 1 und Hohlkathode 2 eingeleitet wird. Weiterhin sind die Hohlkathodenelemente 3 konisch ausgebildet.

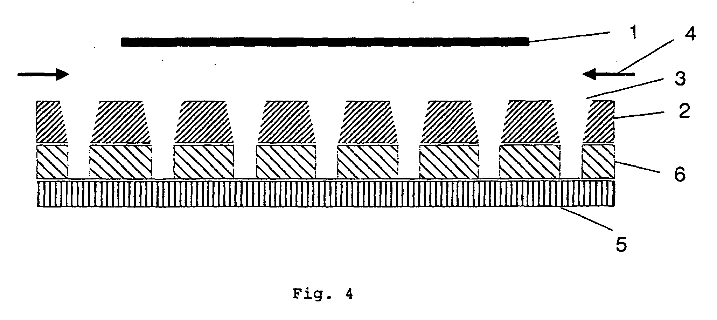

In Fig. 3 ist ein im Winkel von 90° abgekantetes Substrat 1 zu behandeln. Die Hohlkathode 2 und die gekühlte Anode 5 sind der Form des Substrates 1 angepaßt, wobei selbstverständlich auch andere unebene Gegenstände bei entsprechender Anpassung der Hohlkathode 2 bzw. Anode 5 behandelt werden können. Aufgrund dieser Anpassung kann der Abstand zwischen Hohlkathode und Substrat klein gemacht werden. In Fig. 3 wird wiederum das Gas zwischen Anode 5 und Hohlkathode 2 eingeleitet, so daß es durch die Hohlkathodenelemente 3 strömt. Denkbar ist auch, daß die Gasführung 4 nur zwischen Hohlkathode 2 und Substrat 1 vorgesehen ist. Dies ist in Fig. 4 dargestellt, wobei zwischen Kathode 2 und Anode 5 ein Wärmewiderstand 6 angeordnet ist, der eine Keramikplatte sein kann.

Der Abstand zwischen Hohlkathode 2 und Substratoberfläche 1 kann in den dargestellten Ausführungsbeispielen vorzugsweise zwischen 10 µm und 10 mm betragen. Die einzelnen Hohlkathodenelemente 3 können vorzugsweise einen mittleren Durchmesser von 50 µm bis 5 mm und eine Tiefe von 10 µm bis 10 mm aufweisen. Der Abstand der einzelnen Hohlkathodenelemente 3 in der Hohlkathodenmatrix kann einen Wert zwischen dem einfachen Durchmesser bis zehnfachen Durchmesser annehmen. Die Form der einzelnen Hohlkathodenelemente kann zylindrisch, oval, eckig oder konisch sein und die Hohlkathodenelemente können als Durchgangsloch oder Sackloch ausgebildet sein. Entsprechend der Größe des zu beschichtenden Substrats 1 kann die Hohlkathode 2 eine Größe von 1 cm² bis 10 m² aufweisen.

Falls zum Beispiel eine Struktur auf dem Substrat 1 erzeugt werden soll, muß eine lokal unterschiedliche Oberflächenbehandlung vorgenommen werden. Das Muster der Hohlkathode 2 bzw. der Hohlkathodenelemente in der Hohlkathode 2 kann dann entsprechend der gewünschten zu erzeugenden Struktur angepaßt werden und/oder es können verschieden geformte Hohlkathoden 2 zum Beispiel linienförmige, spiralförmige oder dergleichen kombiniert werden.

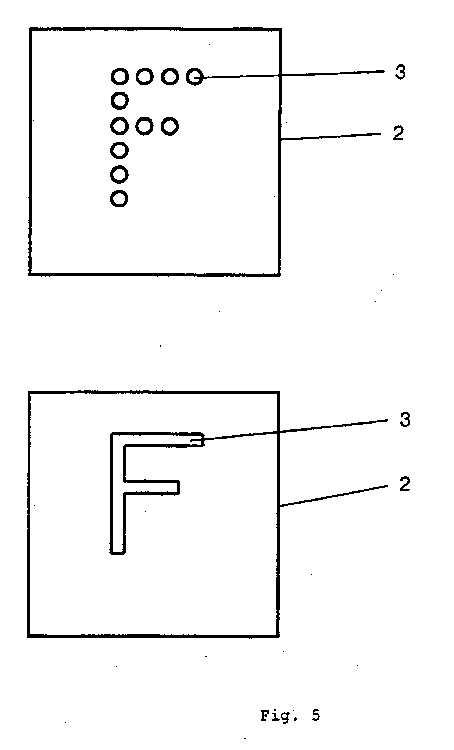

In Fig. 5 ist beispielsweise ein Muster einer Hohlkathode 2 in Form eines F dargestellt, das in Fig. 5 oben aus kreisförmigen Hohlkathodenelementen 3 und unten aus linienförmigen Hohlkathodenelemente 3 besteht.

Zusätzlich zu oder anstelle der Anode kann auch das Substrat gekühlt werden.

## Patentansprüche

1. Verfahren zum Vergüten einer Oberfläche eines Substrats, bei dem in der Nähe des zu behandelnden Substrats (1) ein Plasma durch eine Glimmentladung mittels einer Hohlkathode (2) und einer zugeordneten Anode (5) erzeugt wird und ein sich im Bereich der Glimmentladung befindendes Reaktivgas aktiviert wird, das Oberflächenveränderungen im Sinne der Vergütung am Substrat (1) bewirkt,
**dadurch gekennzeichnet,**
**daß** die Hohlkathode (2) auf Selbstreinigungstemperatur gebracht und gehalten wird, bei der vom Reaktivgas oder vom Substrat (1) herrührende parasitäre Beläge entfernt und/oder umgewandelt werden.

2. Verfahren nach Anspruch 1, **dadurch gekennzeichnet, daß** das Reaktivgas ganz oder teilweise durch die Hohlkathode (2) und/oder im Zwischenraum zwischen Substrat (1) und Hohlkathode (2) an ihr vorbei geleitet wird.

3. Verfahren nach Anspruch 1 oder 2, **dadurch gekennzeichnet, daß** die Temperatur der Hohlkathode (2) auf die Selbstreinigungstemperatur stabilisiert wird, indem die Hohlkathode (2) durch die Glimmentladung geheizt und durch die Anode (5) oder das Substrat (1) gekühlt wird, wobei die Kühlung über die Wärmestrahlung oder die Wärmeleitung durch das Reaktivgas zu der kühlen Anode (5) oder zu dem kühlen Substrat (1) erfolgt.

4. Verfahren nach Anspruch 3, **dadurch gekennzeichnet, daß** die Anode (5) und/oder das Substrat (1) gekühlt wird.

5. Verfahren nach einem der Ansprüche 1 bis 4, **dadurch gekennzeichnet, daß** ein Wärmewiderstand (6) zwischen Anode (5) und Kathode (2) angeordnet wird.

6. Verfahren nach einem der Ansprüche 1 bis 5, **dadurch gekennzeichnet, daß** die Glimmentladung im Grobvakuum oder bei Atmosphärendruck erzeugt wird.

7. Verfahren nach einem der Ansprüche 1 bis 6, **dadurch gekennzeichnet, daß** eine Mehrzahl von Glimmentladungen durch eine Mehrzahl von Hohlkathodenelementen (3) erzeugt werden.

8. Verfahren nach einem der Ansprüche 1 bis 7, **dadurch gekennzeichnet, daß** die Oberfläche des Substrats (1) lokal unterschiedlich behandelt wird.

9. Verfahren nach einem der Ansprüche 1 bis 8, **dadurch gekennzeichnet, daß** die Form und das Muster der Hohlkathode (2) der Form der zu behandelnden Oberfläche und/oder dem gewünschten Muster oder der gewünschten Struktur der Vergütung der Oberfläche des Substrats (1) angepaßt wird.

10. Vorrichtung zum Vergüten der Oberfläche eines Substrats mit einer in fester Zuordnung zum Substrat angeordneten Hohlkathode (2), einer gekühlten Anode (5) und mindestens einem Gaseinlaß (4) zur Zuführung von Reaktivgas, wobei die gekühlte Anode (5) auf der dem Substrat (1) abgewandten Seite der Hohlkathode (2) derart angeordnet ist, daß die Hohlkathode (2) durch die Wirkung der gekühlten Anode (5) und über die Wärmeleitung des Reaktivgases auf eine die Selbstreinigung der Hohlkathode von parasitären Belägen gestattende Temperatur stabilisierbar ist.

11. Vorrichtung nach Anspruch 10, **dadurch gekennzeichnet, daß** die Anode (5) parallel zur Hohlkathode (2) angeordnet ist.

12. Vorrichtung nach Anspruch 10 oder 11, **dadurch gekennzeichnet, daß** zwischen Hohlkathode (2) und Anode (5) ein Wärmewiderstand (6) angeordnet ist.

13. Vorrichtung nach einem der Ansprüche 10 bis 12, **dadurch gekennzeichnet, daß** die Hohlkathode (2) aus einer Mehrzahl von nebeneinander angeordneten Hohlkathodenelementen (3) besteht.

14. Vorrichtung nach Anspruch 13, **dadurch gekennzeichnet, daß** die Hohlkathodenelemente (3) kreis- und/oder linienförmig ausgebildet und/oder matrixförmig angeordnet sind.

15. Vorrichtung nach einem der Ansprüche 10 bis 14, **dadurch gekennzeichnet, daß** die Form der Hohlkathode (2) an die Form bzw. Kontur der zu behandelnden Oberfläche (1) angepaßt ist.

16. Vorrichtung nach einem der Ansprüche 10 bis 15, **dadurch gekennzeichnet, daß** die Form und/oder das Muster der Hohlkathode (2) an eine nach der Behandlung erwünschte Struktur bzw. ein nach der Behandlung erwünschtes Muster der Oberfläche angepaßt ist.

17. Vorrichtung nach einem der Ansprüche 10 bis 14, **dadurch gekennzeichnet, daß** der Gaseinlaß (4) für das Reaktivgas derart angeordnet ist, daß das Gas zumindest teilweise durch die Hohlkathode (2) strömt.

18. Vorrichtung nach einem der Ansprüche 10 bis 17, **dadurch gekennzeichnet, daß** der Abstand zwischen Hohlkathode (2) und Substratoberfläche zwischen 10 µm und 10 mm beträgt.

19. Vorrichtung nach einem der Ansprüche 10 bis 18, **dadurch gekennzeichnet, daß** die einzelnen Hohlkathodenelemente (3) einen mittleren Durchmesser zwischen 50 µm und 5 mm und eine Tiefe zwischen 100 µm und 10 mm aufweisen.

20. Vorrichtung nach einem der Ansprüche 10 bis 19, **dadurch gekennzeichnet, daß** der Abstand zwischen den einzelnen Hohlkathodenelementen (3) das 1-bis 10fache ihres Durchmessers beträgt.

21. Vorrichtung nach einem der Ansprüche 10 bis 20, **dadurch gekennzeichnet, daß** das Substrat gekühlt ist.

## Claims

1. Process for improving a surface of a substrate, in which a plasma is produced by a glow discharge by means of a hollow cathode (2) and an assigned anode (5) in the vicinity of the substrate (1) to be treated and a reactive gas situated in the region of the glow discharge is activated which effects surface changes on the substrate (1) in the sense of improvement, **characterised in that** the hollow cathode (2) is brought and kept at self-cleaning temperature, at which parasitic deposits stemming from the reactive gas and from the substrate (1) are removed and/or converted.

2. Process according to claim 1, **characterised in that** the reactive gas is introduced wholly or partly through the hollow cathode (2) and/or past it in the gap between substrate (1) and hollow cathode (2).

3. Process according to claim 1 or 2, **characterised in that** the temperature of the hollow cathode (2) is stabilised at the self-cleaning temperature by heating the hollow cathode (2) by glow discharge and cooling via the anode (5) or the substrate (1), wherein cooling takes place via heat radiation or heat conduction by the reactive gas to the cool anode (5) or to the substrate (1) to be cooled.

4. Process according to claim 3, **characterised in that** the anode (5) and/or the substrate (1) is cooled.

5. Process according to one of claims 1 to 4, **characterised in that** a thermal resistance (6) is arranged between anode (5) and cathode (2).

6. Process according to one of claims 1 to 5, **characterised in that** the glow discharge is produced in rough vacuum or at atmospheric pressure.

7. Process according to one of claims 1 to 6, **characterised in that** a plurality of glow discharges are produced by a plurality of hollow cathode elements (3).

8. Process according to one of claims 1 to 7, **characterised in that** the surface of the substrate (1) is treated locally differently.

9. Process according to one of claims 1 to 8, **characterised in that** the shape and the design of the hollow cathode (2) is matched to the shape of the surface to be treated and/or the required design or the required structure to refine the surface of the substrate (1).

10. Device for improving the surface of a substrate having a hollow cathode (2) arranged in fixed assignment to the substrate, a cooled anode (5) and at least one gas inlet (4) for supplying reactive gas, wherein the cooled anode (5) is arranged on the side of the hollow cathode (2) facing away from the substrate (1) such that the hollow cathode (2) can be stabilised by the action of the cooled anode (5) and via heat conduction of the reactive gas at a temperature permitting self-cleaning of the hollow cathode from parasitic deposits.

11. Device according to claim 10, **characterised in that** the anode (5) is arranged parallel to the hollow cathode (2).

12. Device according to claim 10 or 11, **characterised in that** a thermal resistance (6) is arranged between hollow cathode (2) and anode (5).

13. Device according to one of claims 10 to 12, **characterised in that** the hollow cathode (2) comprises a plurality of hollow cathode elements (3) arranged next to one another.

14. Device according to claim 13, **characterised in that** the hollow cathode elements (3) are designed to be circular and/or linear and/or arranged like a matrix.

15. Device according to one of claims 9 to 14, **characterised in that** the shape of the hollow cathode (2) is matched to the shape or contour of the surface (1) to be treated.

16. Device according to one of claims 10 to 15, **characterised in that** the shape and/or the design of the hollow cathode (2) is matched to a structure required after treatment or a design on the surface required after treatment.

17. Device according to one of claims 10 to 14, **characterised in that** the gas inlet (4) for the reactive gas is arranged such that the gas flows at least partly through the hollow cathode (2).

18. Device according to one of claims 10 to 17, **characterised in that** the distance between hollow cathode (2) and substrate surface is between 10 µm and 10 mm.

19. Device according to one of claims 10 to 18, **characterised in that** the individual hollow cathode elements (3) have an average diameter between 50 µm and 5 mm and a depth between 100 µm and 10 mm.

20. Device according to one of claims 10 to 19, **characterised in that** the distance between the individual hollow cathode electrodes (3) is 1 to 10 times their diameter.

21. Device according to one of claims 10 to 20, **characterised in that** the substrate is cooled.

## Revendications

1. Procédé de traitement d'une surface d'un substrat, où un plasma est créé à proximité du substrat à traiter (1), par décharge lumineuse, au moyen d'une cathode creuse (2) et d'une anode associée (5), et où un gaz de réaction se trouvant dans la zone de la décharge lumineuse est activé, qui provoque des modifications de la surface allant dans le sens du traitement du substrat (1),
**caractérisé par le fait que** la cathode creuse (2) est portée, puis maintenue à une température d'auto-nettoyage, à laquelle des dépôts parasites résultant du gaz de réaction ou du substrat (1) sont éliminés et/ou convertis.

2. Procédé selon la revendication 1, **caractérisé par le fait que** le gaz de réaction est conduit intégralement ou partiellement à travers la cathode creuse (2) et/ou à côté de celle-ci, dans l'espace compris entre le substrat (1) et la cathode creuse (2).

3. Procédé selon la revendication 1 ou 2, **caractérisé en ce que** la température de la cathode creuse (2) est stabilisée à la température d'auto-nettoyage par le fait que la cathode creuse (2) est chauffée par la décharge lumineuse et refroidie par l'anode (5) ou le substrat (1), le refroidissement s'effectuant par le rayonnement thermique ou la conduction thermique, assuré(e) par le gaz de réaction, en direction de l'anode froide (5) ou en direction du substrat froid (1).

4. Procédé selon la revendication 3, **caractérisé par le fait que** l'anode (5) et/ou le substrat (1) sont refroidis.

5. Procédé selon l'une des revendications 1 à 4, **caractérisé par le fait qu'**une résistance thermique (6) est disposée entre l'anode (5) et la cathode (2).

6. Procédé selon l'une des revendications 1 à 5, **caractérisé par le fait que** la décharge lumineuse est produite dans un vide primaire ou à la pression atmosphérique.

7. Procédé selon l'une des revendications 1 à 6, **caractérisé par le fait qu'**une multitude de décharges lumineuses est produite par une multitude d'éléments de cathodes creuses (3).

8. Procédé selon l'une des revendications 1 à 7, **caractérisé par le fait que** la surface du substrat (1) est traitée de façons différentes par endroits.

9. Procédé selon l'une des revendications 1 à 8, **caractérisé par le fait que** la forme et le dessin de la cathode creuse (2) sont adaptés à la forme de la surface à traiter et/ou au dessin souhaité ou à la texture souhaitée du traitement de la surface du substrat (1).

10. Dispositif de traitement de la surface d'un substrat comprenant une cathode creuse (2) disposée en relation fixe avec le substrat, une anode refroidie (5) et au moins une arrivée de gaz (4) permettant l'alimentation en gaz de réaction, l'anode refroidie (5) étant agencée du côté de la cathode creuse (2), qui est éloigné du substrat (1), d'une manière telle que la cathode creuse (2) puisse être stabilisée, grâce à l'action de l'anode refroidie (5) et grâce à la conduction thermique du gaz de réaction, à une température permettant l'auto-nettoyage de la cathode creuse la débarrassant de dépôts parasites.

11. Dispositif selon la revendication 10, **caractérisé en ce que** l'anode (5) est disposée parallèlement la cathode creuse (2).

12. Dispositif selon la revendication 10 ou 11, **caractérisé en ce qu'**une résistance thermique (6) est placée entre la cathode creuse (2) et l'anode (5).

13. Dispositif selon l'une des revendications 10 à 12, **caractérisé en ce que** la cathode creuse (2) est constituée d'une multitude d'éléments de cathodes creuses (3) disposés les uns à côté des autres.

14. Dispositif selon la revendication 13, **caractérisé en ce que** les éléments de cathodes creuses (3) sont configurés selon une forme circulaire et/ou linéaire et/ou sont disposés en une matrice.

15. Dispositif selon l'une des revendications 10 à 14, **caractérisé en ce que** la forme de la cathode creuse (2.) est adaptée à la forme ou aux contours de la surface à traiter (1).

16. Dispositif selon l'une des revendications 10 à 15, **caractérisé en ce que** la forme et/ou le dessin de la cathode creuse (2) est/sont adapté(es) à une texture souhaitée de la surface, à obtenir à l'issue du traitement, ou à un dessin souhaité de la surface, à obtenir à l'issue du traitement.

17. Dispositif selon l'une des revendications 10 à 14, **caractérisé en ce que** l'arrivée des gaz (4) pour le gaz de réaction est aménagée de manière telle que le gaz passe au moins partiellement dans la cathode creuse (2).

18. Dispositif selon l'une des revendications 10 à 17, **caractérisé en ce que** la distance entre la cathode creuse (2) et la surface du substrat est de l'ordre de 10 µm à 10 mm.

19. Dispositif selon l'une des revendications 10 à 18, **caractérisé en ce que** les différents éléments de cathodes creuses (3) présentent un diamètre moyen compris entre 50 µm et 5 mm et une profondeur comprise entre 100 µm et 10 mm.

20. Dispositif selon l'une des revendications 10 à 19, **caractérisé en ce que** la distance entre les différents éléments de cathodes creuses (3) représente un multiple simple à décuple de leur diamètre.

21. Dispositif selon l'une des revendications 10 à 20, **caractérisé en ce que** le substrat est refroidi.
